(19) Europäisches Patentamt
European Patent Office
Office européen des brevets

(11) **EP 2 702 604 B1**

(12) **FASCICULE DE BREVET EUROPEEN**

(45) Date de publication et mention
de la délivrance du brevet:
**22.02.2017 Bulletin 2017/08**

(21) Numéro de dépôt: **12724152.9**

(22) Date de dépôt: **25.04.2012**

(51) Int Cl.:
**_H01J 37/32_** _(2006.01)_

(86) Numéro de dépôt international:
**PCT/FR2012/050903**

(87) Numéro de publication internationale:
**WO 2012/146870 (01.11.2012 Gazette 2012/44)**

(54) **PROCÉDÉ DE TRAITEMENT MICRO-ONDE D'UNE CHARGE**

VERFAHREN FÜR DIE MIKROWELLENBEHANDLUNG EINER LAST

METHOD FOR THE MICROWAVE TREATMENT OF A LOAD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.04.2011 FR 1153587**

(43) Date de publication de la demande:
**05.03.2014 Bulletin 2014/10**

(73) Titulaire: **Sairem Societe Pour L'application
Industrielle De
La Recherche En Electronique Et Micro Ondes
01700 Neyron (FR)**

(72) Inventeurs:
- **GRANDEMENGE, Adrien**
  **F-69370 Saint-Didier au Mont d'Or (FR)**
- **JACOMINO, Jean-Marie**
  **F-69140 Rilleux-la-Pâpe (FR)**
- **RADOIU, Marilena**
  **F-69009 Lyon (FR)**
- **LATRASSE, Louis**
  **F-39380 Dommartin (FR)**

(74) Mandataire: **Chevalier, Renaud Philippe et al
Cabinet Germain & Maureau
BP 6153
69466 Lyon Cedex 06 (FR)**

(56) Documents cités:
**EP-A1- 1 783 813     EP-A1- 1 918 414
EP-A2- 0 432 573     EP-A2- 0 459 177
EP-A2- 1 643 641     JP-A- 2011 023 356
US-A- 5 324 388**

- **LATRASSE L ET AL: "High density distributed
microwave plasma sources in a matrix
configuration: concept, design and performance;
High density distributed microwave plasma
sources in a matrix configuration", PLASMA
SOURCES SCIENCE AND TECHNOLOGY,
INSTITUTE OF PHYSICS PUBLISHING, BRISTOL,
GB, vol. 16, no. 1, 1 février 2007 (2007-02-01),
pages 7-12, XP020120254, ISSN: 0963-0252, DOI:
10.1088/0963-0252/16/1/002**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention se rapporte à un procédé de traitement micro-onde d'une charge.

L'objet de l'invention se situe dans le domaine du traitement micro-onde consistant à traiter une charge absorbant les micro-ondes par application sur celle-ci d'une onde électromagnétique dans le domaine des micro-ondes ; cette charge pouvant être constitué d'un produit liquide, solide ou gazeux présentant des caractéristiques diélectriques lui permettant d'absorber tout ou partie de l'onde, comme par exemple une suspension aqueuse, un produit agroalimentaire ou chimique, un gaz plasmagène, etc. une telle charge pouvant être contenue à l'intérieur d'une chambre de traitement.

Une première application concerne les traitements micro-onde par production dans une chambre de traitement d'un plasma excité par un rayonnement micro-onde pour diverses applications, comme par exemple et à titre non limitatif les applications de traitement de surface, comme la gravure ou le dépôt de couches de matériau, notamment de diamant, le traitement chimique ou thermochimique, la pulvérisation, la décontamination, la stérilisation, le nettoyage, la nitruration, l'implantation ionique, la désinfection, etc.

Une seconde application concerne les traitements micro-onde par chauffage d'une charge absorbant le rayonnement micro-onde, en particulier dans les domaines de la chimie, du médical ou de l'agroalimentaire.

La divulgation se rapporte plus particulièrement à une installation de traitement micro-onde d'une charge, comprenant :

-  au moins un dispositif d'application d'une onde électromagnétique dans le domaine des micro-ondes ;
-  au moins un générateur d'onde électromagnétique dans le domaine des micro-ondes, raccordé à au moins un dispositif d'application par des moyens de guidage de l'onde électromagnétique.

Une première application de la présente divulgation est de permettre le contrôle de la puissance réfléchie sur le ou chaque dispositif d'application, pour de préférence assurer l'adaptation d'impédance sur le ou chaque dispositif d'application par annulation voire minimisation de la puissance réfléchie sur le ou chaque dispositif d'application.

Une deuxième application de la présente divulgation est de permettre le contrôle de la puissance transmise par le ou chaque dispositif d'application, pour de préférence répartir équitablement la puissance transmise entre les différents dispositifs d'application afin d'obtenir sur une zone de traitement donnée, par exemple à une certaine distance des parois de la chambre de traitement, une densité de puissance sensiblement uniforme. Dans le cas d'une installation de traitement micro-onde par production d'un plasma, il est en effet intéressant d'obtenir un plasma sensiblement uniforme présentant une densité de puissance sensiblement uniforme.

Dans le cas d'une installation de traitement micro-onde par production d'un plasma à la Résonance Cyclotronique Electronique (RCE), une troisième application de la présente divulgation est de permettre le contrôle de la surface de résonance au voisinage de la ou chaque dispositif d'application, et donc le contrôle de la surface de création du plasma dans le voisinage du dispositif d'application concerné, dans le cas particulier d'un plasma.

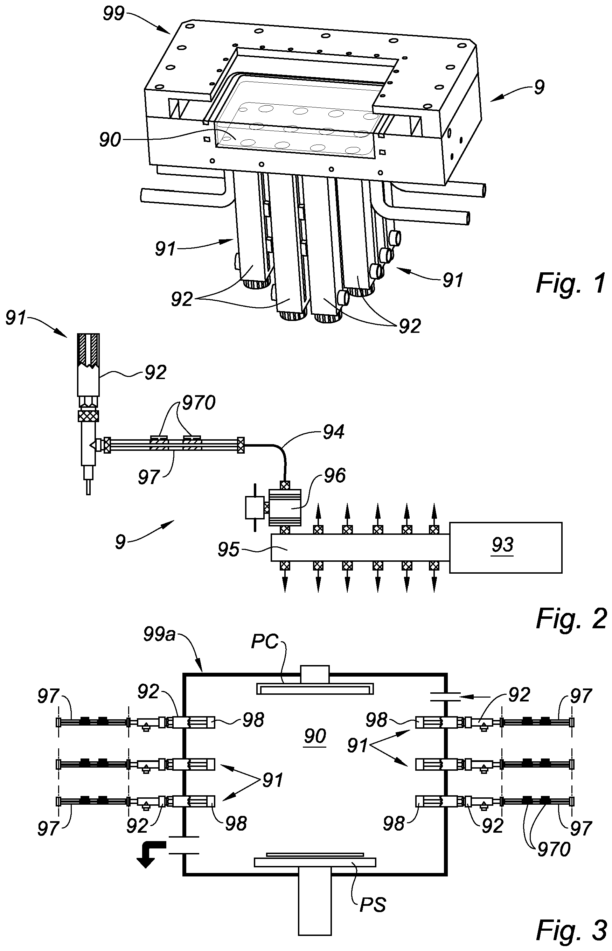

Les figures 1 et 2 illustrent une installation 9 classique de traitement micro-onde par production d'un plasma, connue notamment du document WO 01/20710 A1, qui comprend :

-  un réacteur 99 présentant une chambre de traitement 90 (ou chambre à plasma) dans le volume de laquelle le plasma est produit ;
-  plusieurs sources élémentaires 91 de plasma comprenant chacune un dispositif d'application 92 à l'intérieur de la chambre de traitement 90 d'une onde électromagnétique dans le domaine des micro-ondes ; et
-  un générateur 93 d'onde électromagnétique dans le domaine des micro-ondes, raccordé aux dispositifs d'application 92 par des moyens de guidage 94 de l'onde électromagnétique.

En fonctionnement, le générateur 93, classiquement du type magnétron, produit une onde électromagnétique à une fréquence fixe dans le domaine des micro-ondes. Par exemple, un magnétron 93 permet de fournir une puissance micro-onde variable de 0 à 2 kW à une fréquence fixe de 2,45 GHz.

L'onde électromagnétique délivrée par le magnétron 93 est envoyée vers un diviseur de puissance 95 conçu pour diviser la puissance micro-onde par le nombre k de dispositifs d'application 92, généralement par 2, 4, 8, 10, 12, etc. Dans l'exemple de la figure 2, le nombre k de dispositifs d'application 92 est égal à 12.

Le diviseur de puissance 95 est généralement constitué d'un guide d'onde rectangulaire dans lequel sont implantées k antennes prélevant chacune 1/k de la puissance totale délivrée par le magnétron 93. Dans cette architecture du diviseur de puissance 95, les antennes sont disposées dans le guide, dans lequel sont établies des ondes stationnaires, aux ventres du champ électromagnétique. Cette technologie est efficace dans la mesure où chaque source élémentaire 91 de plasma se comporte comme une impédance adaptée, autrement dit la puissance réfléchie sur chaque dispositif d'application 92 est sensiblement nulle de sorte que chaque source élémentaire 91 transmet sans perte la totalité de la puissance prélevée par l'antenne correspondante.

La puissance prélevée par chaque antenne est ensuite transmise par un moyen de guidage 94, classiquement du type câble coaxial, indépendant à l'un des dispositifs d'application 92 à travers un circulateur 96 équipé d'une charge à eau adaptée placée en sortie du diviseur de puissance 95. Ce circulateur 96 laisse passer la puissance prélevée par chaque antenne du diviseur de puissance vers les dispositifs d'application 92, mais par contre il empêche la puissance réfléchie d'aller du dispositif d'application 92 à l'antenne en redirigeant la puissance réfléchie sur une charge, en l'occurrence la charge à eau.

Les câbles coaxiaux 94 transmettent la puissance aux dispositifs d'application 92, classiquement appelés applicateurs, à travers un adaptateur d'impédance 97, ou tuner, placé juste avant l'applicateur 92 correspondant. Le réglage d'impédance entre le plasma confiné dans la chambre de traitement 90 et chaque source élémentaire 91 de plasma s'effectue en manipulant manuellement l'adaptateur d'impédance 97 de la ligne concernée, afin de permettre de minimiser la puissance réfléchie sur chaque applicateur 92.

La figure 3 illustre un premier exemple de réacteur 99a pour une installation de production de plasma, utilisant des dispositifs d'application 92 du type applicateur coaxial avec un adaptateur d'impédance 97 pour chaque applicateur coaxial 92. Les applicateurs coaxiaux 92 débouchent dans la chambre de traitement 90 sur la paroi cylindrique du réacteur 99a. Ce premier réacteur 99a est un réacteur de dépôt/gravure à basse pression où chaque source élémentaire de plasma 91 comprend en outre une structure magnétique 98 conçue pour engendrer un champ magnétique qui, couplé à une onde électromagnétique de fréquence donnée, permet la production d'un plasma à la Résonance Cyclotronique Electronique (RCE).

Dans ce cas, les sources élémentaires de plasma 91 sont dites sources élémentaires à couplage RCE ou sources dipolaires. Les structures magnétiques sont classiquement réalisées sous la forme d'aimants permanents 98, constituées par exemple d'aimants cylindriques (dipôle magnétique), positionnés sur les extrémités des applicateurs coaxiaux 92.

Ce type de réacteur 99a, mettant en oeuvre une technique d'excitation du plasma à la Résonance Cyclotronique Electronique, couramment appelée technique RCE ou ECR en anglais, est particulièrement bien adapté pour des applications dans la pulvérisation cathodique (PVD) ou la gravure par plasma, en employant un porte-substrat PS polarisable et un porte-cible PC polarisable disposés dans la chambre de traitement 90 sur deux autres parois opposées et parallèles du réacteur 99a. Ce type de réacteur 99a est également adapté au dépôt chimique en phase vapeur assisté par plasma (ou procédé PACVD pour Plasma Assisted Chemical Vapor Deposition), aux procédés hybrides combinant les procédés PVD et PACVD, et à la pulvérisation réactive. Ce type de réacteur 99a opère typiquement à des pressions inférieures au pascal (Pa) mais peut monter jusqu'à plusieurs milliers de pascals suivant l'application.

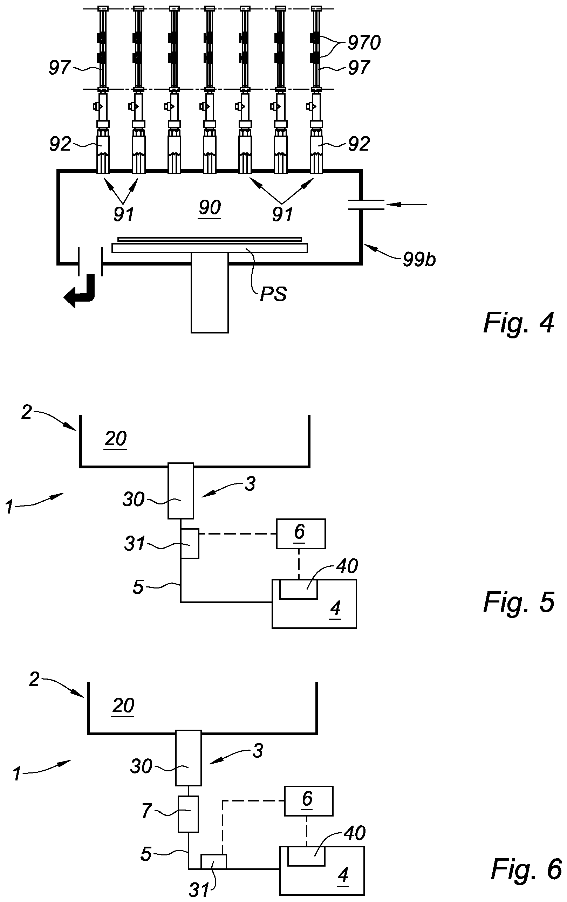

La figure 4 illustre un second exemple de réacteur de 99b pour une installation de production de plasma, utilisant des dispositifs d'application 92 du type applicateur coaxial avec un adaptateur d'impédance 97 pour chaque applicateur coaxial 92. Les applicateurs coaxiaux 92 débouchent dans la chambre de traitement 90 sur une même paroi du réacteur 99b. Dans ce second réacteur 99b, les sources élémentaires de plasma 91 ne comprennent pas de structure magnétique.

Ce type de réacteur 99b, est particulièrement bien adapté pour des applications dans le dépôt/gravure à pression intermédiaire, comme par exemple pour la réalisation de dépôt par PACVD (dépôt chimique en phase vapeur assisté par plasma) ou la gravure plasma, en employant un porte-substrat PS polarisable disposés dans la chambre de traitement 90 sur une paroi du réacteur 99b située en regard des applicateurs coaxiaux 92. Avec ce type de réacteur 99b, les procédés de dépôt chimique fonctionnent très bien dans une gamme de pression intermédiaire, de l'ordre de la centaine de pascals (Pa) permettant ainsi d'obtenir de fortes vitesses de dépôt, mais peut opérer plus exactement de quelques pascals à plusieurs dizaines de milliers de pascals suivant les applications.

Ces installations classiques de production d'un plasma excité par micro-onde présentent cependant de nombreux inconvénients, que l'on rencontre également dans les installations de traitement micro-onde appliquées à la chimie dans des chambres de traitement du type réacteur, à l'agroalimentaire dans des chambres de traitement du type cavité de chauffage, etc.

Un premier inconvénient relève des limitations inhérentes aux adaptateurs d'impédance 97 pour effectuer une adaptation d'indépendance sur chaque dispositif d'application, de tels adaptateurs d'impédance étant par ailleurs également employés dans les installations de traitement micro-onde appliquées à la chimie, au médical (eg. traitement d'une partie du corps, telle qu'une tumeur, par rayonnement micro-onde) ou à l'agroalimentaire (eg. chauffage ou stérilisation d'aliments par rayonnement micro-onde).

De manière connue, l'adaptation d'impédance est une technique permettant d'optimiser le transfert d'une puissance ou énergie électromagnétique, dans le cas présent une puissance ou énergie micro-onde, entre un émetteur, en l'occurrence le générateur d'onde électromagnétique, et un récepteur électrique appelé charge, à savoir le plasma confiné dans la chambre de traitement.

Ainsi, comme décrit ci-dessus, il est classique d'employer dans une installation de traitement micro-onde, un ou plusieurs adaptateurs d'impédance situé entre le dispositif d'application et le générateur d'onde électromagnétique, afin d'en optimiser les performances. L'adaptation d'impédance est dite optimale lorsque la puissance réfléchie par le plasma est nulle, voire la plus faible possible.

Or, toute charge, telle qu'un plasma, un mélange réactionnel chimique ou gazeux, un produit solide, etc., possède une impédance qui varie au cours du temps en fonction des conditions opératoires mis en oeuvre, comme par exemple la pression dans la chambre de traitement, la température dans la chambre de traitement, la nature du ou des gaz introduits dans la chambre de traitement pour créer le plasma, les proportions de ces gaz, la puissance transmise à la charge, la nature de l'énergie électromagnétique transmise à la charge, etc. mais également en fonction des caractéristiques de la chambre de traitement, comme par exemple la matière employée pour ses parois, ses dimensions, sa géométrie, l'état de surface de ses parois, etc.

Ainsi, plus l'installation possède de dispositifs d'application, et plus l'adaptation d'impédance est compliquée et contraignante, en particulier si chaque dispositif d'application possède son propre adaptateur d'impédance manuel et si cette adaptation doit être effectuée pour chaque dispositif d'application et éventuellement pour chaque condition opératoire. Un adaptateur d'impédance peut présenter de nombreuses formes et peut aussi être intégré à l'applicateur.

En référence aux figures 2 à 4, un adaptateur d'impédance 97 coaxial à diélectrique comprend généralement deux anneaux concentriques 970 à l'âme coaxiale, ces anneaux concentriques 970 étant déplaçables le long de l'axe du câble coaxial 94 pour faire varier l'impédance à l'entrée de l'adaptateur d'impédance 97. Les anneaux concentriques 970 constituent des discontinuités diélectriques qui, lorsqu'on les déplace, permettent de régler le coefficient de réflexion. Ainsi, en déplaçant les anneaux concentriques 970, on crée en entrée de l'adaptateur une onde réfléchie en opposition de phase avec l'onde réfléchie par l'applicateur associé mais de même amplitude, ainsi la résultante des puissances réfléchies est nulle et le système est adapté.

Lors d'un procédé de traitement micro-onde, les conditions opératoires changent souvent en cours de route, et les utilisateurs procèdent généralement à un réglage moyen et fixe des adaptateurs d'impédance. De la sorte, l'adaptation d'impédance sera acceptable pour les diverses conditions opératoires utilisées lors du procédé mais ne sera pas optimisée pour chaque condition opératoire, sauf à ce que l'utilisateur refasse manuellement une adaptation à chaque changement de ces conditions opératoires.

Il est également connu d'employer des adaptateurs d'impédance automatiques dans le domaine de la production de plasma, qui intègrent des dispositifs électroniques de commande pilotant en déplacement des éléments mécaniques. Cependant, ces adaptateurs d'impédance automatiques sont particulièrement complexes et coûteux à cause des dispositifs électroniques de commande, et peu réactifs car ils nécessitent le pilotage des éléments mécaniques entre plusieurs positions.

Un second inconvénient concerne la difficulté de maîtriser ou réguler la puissance transmise sur chaque dispositif d'application, voire de répartir équitablement la puissance transmise entre les différents dispositifs d'application ; une bonne répartition favorisant par exemple un chauffage homogène d'un produit agroalimentaire ou d'une composition ou mélange chimique, pour notamment favoriser des réactions ciblées en volume à l'intérieur d'un réacteur chimique, ou la production d'un plasma uniforme, en volume ou en surface, dans la chambre de traitement et à une distance donnée de la ou de ses parois.

En effet, cette difficulté provient, entre autres, des diviseurs de puissance qui ne donnent pas entière satisfaction. Dans le cas d'un générateur à magnétron, le plus gros problème réside dans la division de puissance. En effet, les diviseurs de puissance sont conçus pour diviser la puissance micro-onde à 2,45 GHz équitablement entre plusieurs antennes. Or la fréquence de l'onde émise par le générateur à magnétron varie avec la puissance, et donc la division ne sera équitable que pour une gamme de puissance restreinte qui, de plus, sera différente d'un générateur à l'autre.

Cette difficulté provient également des dispositifs d'application qui peuvent présenter des puissances réfléchies variables d'un dispositif d'application à l'autre. En employant plusieurs dispositifs d'application alimentés par un même générateur, on peut constater dans certains cas une influence de l'impédance d'un dispositif d'application sur les autres dispositifs d'application, en l'absence d'un découplage suffisant entre les lignes d'alimentation des différents dispositifs d'application. On observe ainsi des déséquilibres entre les puissances transmises par les dispositifs d'application, qui nuisent à l'uniformité du chauffage ou du plasma dans la chambre de traitement.

Il est à noter qu'une répartition équitable de la puissance transmise à la charge par les différents dispositifs d'application favorise la production d'un chauffage homogène ou d'un plasma uniforme dans la chambre de traitement, du moins jusqu'à une certaine distance des dispositifs d'application, mais ne garantit pas à elle seule l'obtention d'une telle uniformité, car cette uniformité dépend de la diffusion du chauffage ou du plasma dans la chambre de traitement, qui elle-même dépend principalement, directement ou indirectement, des conditions opératoires (pression, puissance transmise, caractéristiques de la charge, du produit ou du mélange à traiter, etc.) et des dimensions et de la forme de la chambre de traitement.

Dans un premier exemple d'installation, illustrée sur les figures 1 et 4, les dispositifs d'application sont distribuées dans un même plan, dit plan source, selon une maille donnée, par exemple carrée ou hexagonale. En répartissant équitablement la puissance transmise entre ces dispositifs d'application, on obtient un plasma localisé au bout de chaque applicateur et, par diffusion, on obtient un plasma sensiblement uniforme en termes de densité du plasma à une certaine distance du plan de source. Cependant, on peut observer, au fur et à mesure que l'on s'éloigne du plan de source, une variation de densité du plasma. Dans ce cas de figure, on parle d'une uniformité en surface du plasma, car cela correspond à une uniformité du plasma dans des plans parallèles au plan de source.

Dans un second exemple d'installation, illustrée sur la figure 3, les dispositifs d'application sont distribués en couronnes sur la paroi cylindrique du réacteur cylindrique. En répartissant équitablement la puissance transmise entre ces dispositifs d'application, on obtient un plasma sensiblement uniforme en termes de densité du plasma à une certaine distance de la paroi cylindrique. Il est ainsi possible d'obtenir une uniformité sur un large volume de la chambre de traitement, et on parle alors d'une uniformité en volume du plasma, car ce type d'installation fonctionne généralement à très basse pression ; une basse pression favorisant la diffusion des espèces.

Un troisième inconvénient relève de la difficulté de contrôler la surface de résonance dans le cas particulier des installations mettant en oeuvre la technique d'excitation du plasma à la résonance cyclotronique électronique.

En présence d'un champ magnétique B uniforme, les trajectoires des électrons sont des hélices enroulées autour des lignes de champ. Les électrons possèdent une vitesse angulaire ω répondant à l'équation suivante :

$$\omega = 2\pi.f = e.B/m,$$

où m et e correspondent respectivement à la masse et à la charge de l'électron.

Lorsque l'on superpose au champ magnétique B un champ électrique uniforme alternatif de pulsation $\omega_P$, les électrons, en plus de leurs mouvements hélicoïdaux, subissent des forces à la fréquence $f_P = \omega_P/2\pi$.

Avec cette technique RCE, la résonance est obtenue lorsque la fréquence de giration d'un électron dans un champ magnétique statique ou quasi statique est égale à la fréquence du champ électrique accélérateur appliqué. Autrement dit, pour $\omega = \omega_P$, on obtient la condition de résonance cyclotronique électronique, la composante de la vitesse des électrons perpendiculaire au champ magnétique B s'accroît, donnant aux électrons une trajectoire en spirale hélicoïdale (la trajectoire perpendiculaire aux lignes de champ B est une spirale). Ainsi une quantité importante d'énergie est transmise aux électrons, permettant d'ioniser facilement les espèces neutres du gaz lors de collisions. Ce type de plasma fonctionne dans une gamme de pression de l'ordre de $10^{-3}$ mbar (0,1 Pa), qui correspond à une pression suffisamment faible pour permettre aux électrons d'acquérir suffisamment d'énergie entre deux collisions, mais pas trop faible non plus pour qu'il y ait suffisamment de collisions ionisantes pour maintenir le plasma.

Ainsi, la zone de création des espèces excitées dépend du champ magnétique B et de la fréquence f de l'onde émise. Or, actuellement, il est difficile de contrôler la localisation de cette zone de création, autrement dit de contrôler la surface de résonance, sachant qu'un tel contrôle peut présenter de nombreux avantages pour modifier la densité du plasma et donc pour optimiser les performances de l'installation.

La présente divulgation a pour but de résoudre tout ou partie de ces inconvénients, en proposant une installation de traitement micro-onde qui permette de contrôler la puissance réfléchie sur le ou chaque dispositif d'application afin de réaliser l'adaptation d'impédance, de contrôler la puissance transmise par le ou chaque dispositif d'application afin notamment de répartir équitablement la puissance transmise entre les différents dispositifs d'application pour éventuellement obtenir un chauffage ou plasma sensiblement uniforme en volume ou en surface, dans la chambre de traitement, à une distance donnée de la ou de ses parois, et de contrôler la surface de résonance dans le cas particulier des installations mettant en oeuvre la technique d'excitation du plasma à la résonance cyclotronique électronique.

En mettant en oeuvre le réglage de la fréquence de l'onde électromagnétique produite par le ou chaque générateur à état solide, tout en restant bien entendu dans le domaine des micro-ondes, la divulgation permet de solutionner de manière simple et efficace les différents problèmes soulevés par l'état de la technique. En effet, la fréquence influe directement sur la puissance réfléchie, et donc sur l'adaptation d'impédance, sur la puissance transmise, et donc sur l'uniformité du plasma, et également sur la surface de résonance dans le cas des installations mettant en oeuvre la technique d'excitation du plasma à la résonance cyclotronique électronique.

L'innovation consiste ainsi en l'utilisation d'un ou plusieurs générateurs à état solide et d'un ou plusieurs systèmes de réglage fréquentiel (en l'occurrence un par générateur) permettant de faire varier la fréquence de l'onde électromagnétique générée par le générateur à état solide correspondant.

Les générateurs à état solide, autrement appelés générateurs d'onde électromagnétique à transistor, sont en effet particulièrement bien adaptés pour faire varier la fréquence de l'onde, de manière automatique (par exemple avec un programme de contrôle informatique sur ordinateur ou avec un automate), pour chaque dispositif d'application.

Concernant les définitions des puissances, on a : $P_{T(i)}$ correspond à la puissance transmise par le dispositif d'application (i) à la charge, $P_{R(i)}$ correspond à la puissance réfléchie par le dispositif d'application (i), $P_{IN(i)}$ correspond à la puissance incidente transmise au dispositif d'application (i) par le générateur associé ; cette puissance incidente $P_{IN(i)}$ étant égale à la puissance fournie par le générateur concerné, aux pertes de lignes près, si un générateur alimente un seul et même dispositif d'application.

Avec la divulgation, trois utilisations privilégiées, mais non nécessairement limitatives, sont envisageables.

Une première utilisation consiste à faire varier la fréquence de l'onde produite par le ou chaque générateur, pour contrôler la puissance réfléchie $P_{R(i)}$ sur le ou chaque dispositif d'application (i). De cette manière, on peut minimiser, éventuellement jusqu'à annulation, la puissance réfléchie $P_{R(i)}$ sur le ou chaque dispositif d'application (i), réalisant ainsi une adaptation d'impédance.

Concernant l'adaptation d'impédance, plusieurs phénomènes rentrent en compte : l'un d'entre eux étant que l'impédance même de la charge, comme par exemple dans le cas d'un plasma ou de certains produits chimiques réactifs, change localement car elle dépend entre autres de la puissance transmise à la charge, elle-même dépendante de l'adaptation d'impédance donc également de la fréquence puisque celle-ci influe l'adaptation d'impédance.

Cette première utilisation permet de se passer des adaptateurs d'impédance dans certains cas mais, dans d'autres cas, elle offre un degré de réglage supplémentaire pour l'adaptation d'impédance sans pour autant se passer complètement des adaptateurs d'impédance. Ainsi, si le réglage de l'impédance est satisfaisant au début d'un procédé (avec ou sans l'utilisation d'adaptateurs d'impédance) et que la charge se désadapte (par exemple lors d'un changement des conditions opératoires), alors il est permis d'adapter à nouveau l'impédance en faisant varier la fréquence f(i) de l'onde électromagnétique, et ce pour le générateur ou pour chaque générateur individuellement.

Ainsi, quelle que soit la cause du désaccord d'impédance (en début ou en cours de procédé), la puissance réfléchie peut être minimisée, voire annulée, en faisant varier la fréquence de l'onde électromagnétique, et ce quel que soit le type de dispositif d'application. En effet, la divulgation n'est pas limitée à une architecture spécifique du ou des dispositifs d'application, qui peuvent être du type applicateur coaxial (avec ou sans structure magnétique), tube de décharge (surfatron, cavité Evenson, source downstream, torche plasma semi-métallique, etc.), antenne, guide d'onde avec une fenêtre diélectrique, etc.

Cette innovation trouve un intérêt dans toutes les applications de traitement micro-onde, comme par exemple un procédé de chauffage ou d'application d'un rayonnement micro-ondes dans un réacteur chimique, un procédé plasma (gravure, dépôt de couches de matériau, traitement chimique ou thermochimique, pulvérisation, décontamination, stérilisation, nettoyage, nitruration, implantation ionique, désinfection, etc.), un procédé de traitement médical par application d'un rayonnement micro-onde, car toutes ces applications nécessitent un accord d'impédance afin d'optimiser leurs performances en termes de densité ionique, densité d'espèces réactives, densité des espèces excitées, températures partielles des espèces, etc.

Une deuxième utilisation consiste à faire varier la fréquence $f_{(i)}$ de l'onde produite par le ou chaque générateur, pour contrôler la puissance transmise $P_{T(i)}$ à la charge par le ou chaque dispositif d'application (i). De cette manière, on peut répartir équitablement la puissance transmise $P_{T(i)}$ entre les différents dispositifs d'application (i), autrement dit faire en sorte d'avoir sensiblement la même puissance transmise $P_{T(i)}$ pour chaque dispositif d'application, pour éventuellement obtenir un chauffage ou un plasma uniforme en volume ou en surface dans la chambre de traitement, à une distance donnée de la ou de ses parois.

Un tel contrôle de la puissance transmise sur chacun des dispositifs d'applications (i) permet également de créer des disparités locales, en faisant en sorte que les dispositifs d'applications (i) ne transmettent pas toutes la même puissance $P_{T(i)}$ afin par exemple de compenser des effets de bords (qui peuvent être dus à une perte de densité du plasma à proximité des parois) pour favoriser des dépôts uniforme ou à l'inverse de créer des gradients de densité du plasma pour faire par exemple des dépôts progressifs, non uniformes ou avec des vitesses de dépôts contrôllées.

Dans les deux premières utilisations, il est permis de contrôler, en faisant varier la fréquence $f_{(i)}$ pour le ou chaque dispositif d'applications (i), la puissance réfléchie $P_{R(i)}$ ou la puissance transmise $P_{T(i)}$ sur chaque dispositif d'applications (i), que ce soit pour minimiser la puissance réfléchie $P_{R(i)}$ dans un souci d'adaptation d'impédance ou que ce soit pour faire prendre à la puissance transmise $P_{T(i)}$ une valeur prédéfinie.

En effet, pour chaque dispositif d'applications (i) (i étant un entier compris entre 1 et N, N étant le nombre de dispositifs d'applications), la puissance transmise $P_{T(i)}$ correspond à la différence entre la puissance incidente $P_{IN(i)}$ transmise au dispositif d'application correspondant (cette puissance incidente étant égale, aux pertes en lignes près, à la puissance fournie par le générateur associé dans le cas ou un générateur alimente un seul dispositif d'application) et la puissance réfléchie $P_{R(i)}$ sur ce même dispositif d'application, soit la relation suivante : $P_{T(i)} = P_{IN(i)} - P_{R(i)}$.

Ainsi, contrôler la puissance réfléchie $P_{R(i)}$ en faisant varier la fréquence $f_{(i)}$ revient à contrôler la puissance transmise $P_{T(i)}$, et inversement. Il est bien entendu envisageable de jouer, en complément de la fréquence $f_{(i)}$, sur la puissance incidente $P_{IN(i)}$ pour réguler la puissance transmise $P_{T(i)}$, sachant que l'on peut jouer sur la puissance incidente $P_{IN(i)}$ notamment en jouant sur la puissance fournie par le générateur associé.

Une troisième utilisation qui concerne les installations mettant en oeuvre la technique de plasma à la Résonance Cyclotronique Electronique (RCE), consiste à faire varier la fréquence de l'onde produite par le ou au moins un générateur, pour contrôler la surface de résonance sur la ou chaque dispositif d'application et donc la densité de puissance du plasma dans une zone de la chambre de traitement proche du dispositif d'application concerné.

Selon une caractéristique, le ou chaque système de réglage fréquentiel est conçu pour régler la fréquence de l'onde électromagnétique dans une plage de fréquence choisie dans le domaine des micro-ondes, comme par exemple dans une plage de fréquence comprise entre environ 2400 et 2500 MHz, ou par exemple entre environ 5725 et 5875 MHz, voire dans une autre plage de fréquence prédéterminée appartenant au domaine des micro-ondes.

Par exemple, dans le cas d'une gamme de fréquence variable entre 2400 et 2500 MHz, le générateur délivre une onde électromagnétique à une fréquence centrale de 2450 MHz, avec une variation de plus ou moins 50 MHz autour de cette fréquence centrale, restant ainsi dans le domaine des micro-ondes ; cette variation sur une plage totale de 100 MHz permettant de répondre à l'essentiel des problématiques rencontrées d'adaptation d'impédance autour de 2450 MHz.

Bien entendu, la divulgation n'est pas limitée à cette plage de fréquence spécifique, ni à une fréquence centrale d'utilisation donnée. La présente divulgation est valable dans le domaine des micro-ondes et le choix de la plage de fréquence dépendra essentiellement de la technologie du ou des générateurs à état solide employés dans l'installation, et également des normes et/ou règlements en usage.

Selon une possibilité de la divulgation, l'installation comprend au moins deux générateurs associés chacun à un système de réglage fréquentiel et au moins deux dispositifs d'application, chaque générateur étant raccordé à au moins un dispositif d'application.

Dans cette configuration, chaque générateur délivre son onde électromagnétique à un ou plusieurs dispositifs d'application. En employant plusieurs générateurs, on améliore les possibilités de réglage individuel de la puissance réfléchie, de la puissance transmise et/ou de la surface de résonance, dispositif d'application par dispositif d'application, en limitant les interactions entre les dispositifs d'application.

Pour remarque, si un générateur est associé à plusieurs dispositifs d'application (i), alors la fréquence $f_{(i)}$ pour ces dispositifs d'application (i) est la même pour chacune d'entre elles et correspond à la fréquence de l'onde générée par ce générateur commun.

Le ou chaque générateur à état solide peut être soit constitué d'un seul et unique générateur à une puissance donnée, soit de plusieurs sous-générateurs. Par exemple, pour un générateur à état solide délivrant une puissance de 200 Watts, on peut soit avoir un seul et unique générateur à état solide avec une puissance de 200 Watts, soit avoir deux sous-générateurs à état solide avec chacun une puissance de 100 Watts. Bien entendu, les sous-générateurs doivent être en phase et comportent donc un système de réglage fréquentiel commun.

Selon une autre possibilité de la divulgation, l'installation comprend N générateurs associés chacun à un système de réglage fréquentiel, et N dispositifs d'application, où N est un entier supérieur à 2, chaque générateur étant raccordé à un unique dispositif d'application.

Cette configuration est particulièrement avantageuse, car chaque dispositif d'application (i) est alimenté en puissance ou énergie micro-onde par un seul et unique générateur, et inversement chaque générateur alimente un seul et unique dispositif d'application. Ainsi, aucun diviseur de puissance n'est nécessaire, et le réglage de la puissance réfléchie sur chaque dispositif d'application s'effectue par le réglage de la fréquence sur le générateur correspondant, et ce de manière indépendante entre les dispositifs d'application, limitant ainsi les problèmes d'interaction entre les dispositifs d'application et de division des ondes électromagnétiques.

En outre, il est à noter que le réglage de la fréquence $f_{(i)}$ pour le ou chaque générateur se fait en réponse à une commande automatisée avec le moyen de commande automatisée, par exemple du type automate, processeur ou ordinateur.

L'avantage d'un moyen de commande automatisée est de pouvoir effectuer un réglage automatique de fréquence pour chaque générateur, jusqu'à par exemple minimisation de la puissance réfléchie $P_{R(i)}$ sur les dispositifs d'application (i) pour une adaptation d'impédance, contrôle de la puissance transmise $P_{T(i)}$ sur les dispositifs d'application (i) et contrôle des surfaces de résonance.

La réalisation est particulièrement adaptée pour le contrôle de la puissance réfléchie $P_{R(i)}$ permettant l'adaptation d'impédance (condition a), et pour la régulation de la puissance transmise $P_{T(i)}$ permettant notamment d'obtenir un plasma uniforme (condition b). Pour rappel, contrôler la puissance réfléchie $P_{R(i)}$ en faisant varier la fréquence revient à contrôler la puissance transmise $P_{T(i)}$, et inversement. Autrement dit, les deux conditions a) et b) sont sensiblement équivalentes.

Pour chaque dispositif d'application (i) correspondent une première valeur de référence $V_{R(i)}$ de la puissance réfléchie $P_{R(i)}$ et une seconde valeur de référence $V_{P(i)}$ pour la puissance transmise $P_{T(i)}$. Autrement dit, les valeurs de référence $V_{R(i)}$ et $V_{P(i)}$ ne sont pas nécessairement égales d'un dispositif d'application (i) à l'autre.

Plus concrètement, lors d'un changement des conditions opératoires, le moyen de commande automatisée va être informé en temps réel d'une variation de la puissance réfléchie $P_{R(i)}$ sur un ou plusieurs dispositifs d'application (i) (condition a) ou d'une variation de la puissance transmise $P_{T(i)}$ par une ou plusieurs dispositifs d'application (i) (condition b), après réception des mesures en provenance des systèmes de mesure, et, par une simple boucle d'asservissement, le moyen de commande automatisée va réguler la puissance réfléchie $P_{R(i)}$ et notamment la minimiser (condition a) ou réguler la puissance transmise $P_{T(i)}$ notamment pour qu'elle soit la même sur chaque dispositif d'application (condition b) en faisant varier la fréquence $f_{(i)}$ de l'onde électromagnétique pour le dispositif d'application (i). Ainsi, l'accord d'impédance (condition a) ou la régulation de la puissance transmise (condition b), en vue par exemple d'obtenir l'uniformité du chauffage ou du plasma, est automatiquement réalisé.

De manière plus générale, la puissance réfléchie $P_{R(i)}$ ou transmise $P_{T(i)}$ peut être régulée automatiquement par le moyen de commande selon une boucle d'asservissement en faisant varier la fréquence $f_{(i)}$ de l'onde électromagnétique, et ce quelque soit le type de dispositif d'application (i). Comme présenté plus précisément ci-après, il est bien entendu envisageable de jouer, en complément de la fréquence $f_{(i)}$, sur la puissance incidente $P_{IN(i)}$ pour réguler la puissance transmise $P_{T(i)}$.

Dans une réalisation particulière, la première valeur de référence $V_{R(i)}$ correspond, pour le ou chaque dispositif d'application (i), à un minimum de la puissance réfléchie $P_{R(i)}$ mesurée afin de réaliser une adaptation d'impédance sur le ou chaque dispositif d'application (i) ; ce minimum étant éventuellement égal ou proche de zéro. Ce minimum de puissance réfléchie peut bien entendu correspondre à une puissance réfléchie seuil prédéterminée qui est fixée par défaut dans le programme ou par l'utilisateur, soit en termes de puissance seuil exprimée en Watt soit en termes de pourcentage du rapport de la puissance réfléchie sur la puissance incidente.

Cette réalisation aboutit donc à une adaptation d'impédance, la première valeur de référence qu'atteindra la puissance réfléchie $P_{R(i)}$ sur chaque dispositif d'application (i), suite à une boucle d'asservissement, est fixée sensiblement à zéro, ou du moins à une valeur minimale accessible, ce qui revient à minimiser automatiquement la puissance réfléchie $P_{R(i)}$ sur chaque dispositif d'application (i) en faisant varier la fréquence $f_{(i)}$ de l'onde électromagnétique. Autrement dit, pour l'adaptation d'impédance, le moyen de commande automatisée fera varier la fréquence $f_{(i)}$ jusqu'à trouver un minimum de la puissance réfléchie $P_{R(j)}$.

Selon une réalisation avantageuse où l'installation comprend plusieurs dispositifs d'application (i), la seconde valeur de référence $V_{T(i)}$ correspond, pour chaque dispositif d'application (i), à une valeur de consigne $VC_T$ prédéterminée identique pour chacun des dispositifs d'application (i), afin notamment de favoriser l'obtention d'un chauffage ou d'un plasma uniforme en volume ou en surface dans la chambre de traitement, à une distance donnée de la ou des parois délimitant ladite chambre de traitement, en distribuant sensiblement équitablement la puissance transmise à la charge.

Cette réalisation aboutit donc à une régulation de la puissance transmise $P_{T(i)}$ sur chacun des dispositifs d'application (i), qui trouve un intérêt particulier pour les procédés plasma requérant une grande uniformité, cette régulation automatique de la puissance transmise $P_{T(i)}$ sur chaque dispositif d'application (i) visant à obtenir la même puissance transmise $P_{T(i)}$ sur chaque dispositif d'application (i). Autrement dit, l'objectif n'est plus de minimiser systématiquement la puissance réfléchie $P_{R(i)}$ sur chaque dispositif d'application (i) (pour l'adaptation d'impédance), mais d'avoir une même puissance transmise $P_{T(i)}$ sur chaque dispositif d'application (i).

Ainsi, pour la régulation de la puissance transmise $P_{T(i)}$ à une dispositif d'application (i), le moyen de commande automatisée fait varier la fréquence $f_{(i)}$, et éventuellement en complément la puissance incidente $P_{IN(i)}$, pour que la puissance transmise sur le dispositif d'application $P_{T(i)} = P_{IN(i)} - P_{R(i)}$ soit égale à la valeur de consigne voulue pour ce même dispositif d'application; $P_{T(i)}$ et $P_{R(i)}$ étant des fonctions de la fréquence $f_{(i)}$ et de la puissance incidente $P_{IN(i)}$.

Pour favoriser l'obtention d'un chauffage ou plasma uniforme, du moins à une certaine distance des dispositifs d'application, chaque dispositif d'application (i) recevra donc la même valeur de consigne $VC_T$ pour la puissance transmise $P_{T(i)}$, de sorte que les puissances transmises $P_{T(i)}$ des différents dispositifs d'application (i) soient toutes égales, sachant que la puissance incidente $P_{IN(i)}$ peut varier d'un dispositif d'application (i) à l'autre.

Par exemple, le dispositif d'application (1) présente 150 W de puissance incidente (soit $P_{IN(1)} = 150$ W) et 10 W de puissance réfléchie (soit $P_{R(1)} = 10$ W), tandis que le dispositif d'application (2) présente 142 W de puissance incidente (soit $P_{IN(2)} = 142$ W) et 2 W de puissance réfléchie (soit $P_{R(2)} = 2$ W). Ainsi, le dispositif d'application (1) et le dispositif d'application (2) transmettront chacune une puissance transmise au plasma $P_{T(1)} = P_{T(2)} = 140$ W. Cette situation correspond à un asservissement de la puissance réfléchie $P_{R(1)}$ pour le dispositif d'application (1) à la valeur de 10 W et à un asservissement de la puissance réfléchie $P_{R(2)}$ pour le dispositif d'application (2) à la valeur de 2 W, en jouant sur la fréquence $f_{(1)}$ de l'onde électromagnétique sur le dispositif d'application (1) d'une part et sur la fréquence $f_{(2)}$ de l'onde électromagnétique sur le dispositif d'application (2) d'autre part. Le cas échéant, il est également possible de jouer sur la puissance incidente $P_{IN(i)}$ sur chacun des dispositifs d'application (i), en agissant sur les générateurs associés aux dispositifs d'application (i).

En variante, et toujours dans le cadre de la condition b) et de la régulation de la puissance transmise $P_{T(i)}$, il est également envisageable que le moyen de commande automatisée fasse varier la fréquence $f_{(i)}$, et éventuellement en complément la puissance incidente $P_{IN(i)}$, pour que la puissance transmise $P_{T(i)}$ varie d'un dispositif d'application (i) à l'autre. Dans ce cas, les secondes valeurs de référence $V_{T(i)}$ ne sont pas toutes identiques, afin d'obtenir par exemple une disparité contrôlée du chauffage ou du plasma dans la chambre de traitement.

Cette variante a un intérêt si l'on désire une disparité voulue sur les dispositifs d'application, notamment pour compenser des effets de bords ou pour créer un gradient de puissance transmise le long d'une ligne de dispositifs d'application pour, par exemple, réaliser des dépôts progressifs, obtenir un traitement de surface à intensité variable, ou effectuer un contrôle progressif du traitement lors d'un procédé continu.

Selon une possibilité de la divulgation où l'installation comprend plusieurs dispositifs d'application (i), le moyen de commande automatisée est relié au ou à chaque générateur afin de recevoir en entrée la valeur de la puissance incidente $P_{IN(i)}$ associée à chaque dispositif d'application (i), et le moyen de commande est conçu pour remplir la condition b) en mettant en oeuvre les sous-étapes suivantes lors de l'étape e2) de contrôle :

e3) calculer, pour chaque dispositif d'application (i), une valeur de consigne $VC_{R(i)}$ de la puissance réfléchie $P_{R(i)}$ correspondant à une puissance transmise $P_{T(i)}$ par le dispositif d'application (i) égale à la seconde valeur de référence $V_{T(i)}$, soit $VC_{R(i)} = P_{IN(i)} - V_{T(i)}$ ;

e4) contrôler, pour chaque dispositif d'application (i), le système de réglage fréquentiel concerné pour faire varier la fréquence $f_{(i)}$ de l'onde électromagnétique produite par le générateur associé, afin d'asservir la puissance réfléchie $P_{R(i)}$ à ladite valeur de consigne $VC_{R(i)}$.

De cette manière, on réalise une boucle d'asservissement sur la puissance réfléchie $P_{R(i)}$ pour chaque dispositif d'application (i), afin de remplir la condition b), et donc réaliser une régulation de la puissance transmise $P_{T(i)}$.

Selon une autre possibilité de la divulgation, le moyen de commande pilote le ou chaque générateur en puissance pour que le ou chaque générateur délivre une puissance incidente $P_{IN(i)}$ donnée, et le moyen de commande est conçu pour réaliser l'étape e2), et remplir les conditions a) et/ou b), en contrôlant à la fois le ou chaque système de réglage fréquentiel pour faire varier la fréquence $f_{(i)}$ associée, et le ou chaque générateur pour faire varier la puissance incidente $P_{IN(i)}$ associée.

De cette manière, le moyen de commande joue, pour le ou chaque dispositif d'application, à la fois sur la fréquence et sur la puissance incidente pour remplir la condition a) et/ou la condition b). Jouer en plus sur la puissance incidente permet en effet d'affiner la régulation de la puissance réfléchie et/ou de la puissance transmise, ces deux puissances étant elles-mêmes fonction à la fois de la fréquence et de la puissance incidente.

De manière avantageuse, dans le cadre de ce double pilotage en fréquence et en puissance incidente, le moyen de commande est conçu pour, lors de la sous-étape e4), contrôler, pour chaque dispositif d'application (i), à la fois :

- le générateur concerné pour qu'il délivre une puissance incidente $P_{IN(i)}$ à une valeur de consigne $VC_{IN(i)}$ donnée, éventuellement variable ; et
- le système de réglage fréquentiel concerné pour faire varier la fréquence $f_{(i)}$ de l'onde électromagnétique produite par le générateur associé, afin d'asservir la puissance réfléchie $P_{R(i)}$ à la valeur de consigne $VC_{R(i)}$ qui répond à la relation suivante : $VC_{R(i)} = VC_{IN(i)} - V_{T(i)}$.

Cette technique est avantageuse car elle permet de jouer à la fois sur la fréquence $f_{(i)}$ et sur la puissance incidente $P_{IN(i)}$ pour remplir la condition b), et donc réaliser une régulation de la puissance transmise $P_{T(i)}$. Il est bien entendu que l'on peut faire varier la valeur de consigne $VC_{IN(i)}$ de la puissance incidente $P_{IN(i)}$ en cours de réglage, pour obtenir au final la meilleure régulation de la puissance transmise $P_{T(i)}$.

Dans un mode de réalisation avantageux où l'installation comprend plusieurs dispositifs d'application, le moyen de commande est relié au ou à chaque générateur afin de recevoir en entrée la valeur de la puissance incidente $P_{IN(i)}$ associée à chaque dispositif d'application et de piloter le ou chaque générateur en puissance pour que le ou chaque générateur délivre une puissance incidente $P_{IN(i)}$ donnée, et le moyen de commande est conçu pour remplir les deux conditions a) et b) en mettant en oeuvre les sous-étapes suivantes lors de l'étape e2) de contrôle :

e5) contrôler chaque système de réglage fréquentiel pour faire varier la fréquence $f_{(i)}$ de l'onde électromagnétique produite par le générateur concerné jusqu'à ce que la condition a) soit remplie, de sorte que chaque puissance réfléchie $P_{R(i)}$ est égale à la première valeur de référence $V_{R(i)}$ correspondante ;

e6) calculer, pour chaque dispositif d'application, une valeur de consigne $VC_{IN(i)}$ de la puissance incidente $P_{IN(i)}$ correspondant à une puissance transmise $P_{T(i)}$ par le dispositif d'application égale à la seconde valeur de référence $V_{T(i)}$, soit $VC_{IN(i)} = V_{R(i)} + V_{T(i)}$ ;

e7) piloter le ou chaque générateur pour qu'il délivre une puissance incidente $P_{IN(i)}$ à la valeur de consigne $VC_{IN(i)}$, afin de remplir la condition b).

Ce mode de réalisation est avantageux car il permet de jouer d'abord sur la fréquence $f_{(i)}$ pour remplir la condition a) (et donc assurer la régulation de la puissance réfléchie $P_{R(i)}$, notamment dans un souci d'adaptation d'impédance) et ensuite de jouer sur la puissance incidente $P_{IN(i)}$ pour remplir la condition b) (et donc assurer la régulation de la puissance transmise $P_{T(i)}$, notamment dans un souci d'uniformité du chauffage ou du plasma).

Bien entendu, lors du réglage de la puissance incidente $P_{IN(i)}$ (étape e7)), la puissance réfléchie $P_{R(i)}$ peut changer de valeur, donc la puissance incidente $P_{IN(i)}$ doit varier effectivement jusqu'à ce que sa valeur de consigne $VC_{IN(i)}$ soit atteinte mais en tenant toujours compte de la valeur réelle de la puissance réfléchie $P_{R(i)}$. Ainsi, l'étape e2) de contrôle est une étape dynamique ou continue, en temps réel, qui peut présenter des itérations pour s'adapter en continu aux variations des puissances réfléchies $P_{R(i)}$ et des puissances incidentes $P_{IN(i)}$.

De manière avantageuse, le moyen de commande est conçu pour, lors de l'étape e2) de contrôle, mettre en oeuvre, avant la sous-étape e5), une sous-étape e8) qui consiste à piloter le ou chaque générateur pour qu'il délivre une puissance incidente $P_{IN(i)}$ à une valeur proche ou sensiblement égale à la seconde valeur de référence $V_{T(i)}$.

Cette sous-étape e8) permet ainsi, avant de jouer sur la fréquence $f_{(i)}$ lors de la sous-étape e5), d'avoir la puissance incidente $P_{IN(i)}$ qui se rapproche de sa valeur finale, à savoir la valeur de consigne $VC_{IN(i)}$. Ainsi, on a successivement les sous-étapes suivantes :

e8) au début, le moyen de commande contrôle le ou chaque générateur pour régler la ou chaque puissance incidente $P_{IN(i)}$ à une valeur proche ou égale à la seconde valeur de référence $V_{T(i)}$ ;
e5) réglage de la ou chaque fréquence $f_{(i)}$ pour remplir la condition a), afin de réguler la ou chaque puissance réfléchie $P_{R(i)}$;
e6) et e7) une fois la ou chaque puissance réfléchie $P_{R(i)}$ régulée, il n'y aura plus que quelques watts à ajouter pour que la ou chaque puissance incidente $P_{IN(i)}$ atteigne sa valeur de consigne $VC_{IN(i)}$.

Dans un mode de réalisation particulier, l'installation comprend en outre au moins une structure magnétique conçue pour engendrer un champ magnétique de résonance qui, combiné à l'onde électromagnétique, permet de produire un plasma à la résonance cyclotronique électronique, et le moyen de commande est conçu pour :

f1) calculer une consigne de fréquence $Cf_{(i)}$, pour le ou chaque système de réglage fréquentiel, correspondant à une valeur prédéterminée d'une surface de résonance cyclotronique électronique pour le ou chaque dispositif d'application ;
f2) contrôler, pour chaque dispositif d'application, le système de réglage fréquentiel concerné pour asservir la fréquence $f_{(i)}$ de l'onde électromagnétique produite par le ou chaque générateur à la valeur de consigne $Cf_{(i)}$ correspondante, afin que la surface de résonance cyclotronique électronique du ou de chaque dispositif d'application atteigne la valeur prédéterminée correspondante.

Dans le cas particulier d'une technique d'excitation du plasma à la résonance cyclotronique électronique (RCE), il est permis ainsi de faire varier la valeur de la surface de résonance cyclotronique électronique en faisant varier la fréquence de l'onde pour la ou les dispositifs d'application, et donc de contrôler la géométrie des zones de création du plasma. Faire varier la surface de résonance est un avantage supplémentaire de la variation de la fréquence, car cette surface de résonance est un paramètre influant sur les caractéristiques et la performance du plasma.

Dans une réalisation particulière, le ou chaque dispositif d'application comprend une structure magnétique, et en variante la structure magnétique est intégrée à la chambre de traitement et non aux dispositifs d'application.

Dans le cas de cette technique RCE, chaque fréquence va correspondre à une surface de résonance précise, dépendant de la structure magnétique intégrée ou non au dispositif d'application. Ainsi, pour une même puissance transmise, à deux fréquences différentes, la densité du plasma peut être différente en un point dans le volume de la chambre de traitement, car la surface de résonance varie en fonction de la fréquence.

Par exemple, pour des applicateurs coaxiaux utilisant des aimants permanents, ceux-ci étant généralement situés en bout des applicateurs décrit ci-dessus, la zone de résonance va s'éloigner du dispositif d'application de plasma si l'on diminue la fréquence (car le champ magnétique diminue aussi en s'éloignant du dispositif d'application), permettant ainsi d'augmenter la surface de création active (espèces excitées, espèces ionisées, radicaux...). A contrario, la surface de création peut diminuer en augmentant la fréquence, permettant ainsi de concentrer la zone de création proche du dispositif d'application et donc d'augmenter la densité du plasma localement, bien que cela augmente aussi les pertes sur la source élémentaire.

L'invention se rapporte à un procédé de traitement micro-onde d'une charge, tel que défini dans la revendication 1, et comprenant les étapes suivantes :

- génération d'au moins une onde électromagnétique dans le domaine des micro-ondes par au moins un générateur du type à état solide ;
- guidage de la ou chaque onde électromagnétique à destination d'au moins un dispositif d'application de l'onde électromagnétique ;
- application par le ou chaque dispositif d'application de la ou chaque onde électromagnétique sur la charge ;
- une étape de réglage automatisé de la fréquence de la ou chaque onde électromagnétique afin de minimiser la puissance réfléchie $P_{R(i)}$ sur le ou chaque dispositif d'application pour assurer une adaptation d'impédance permettant d'optimiser le transfert de la ou chaque onde électromagnétique à destination de la charge, de manière automatique et en temps réel, avec les étapes suivantes :

p1) mesure, pour le ou chaque dispositif d'application, de la puissance réfléchie $P_{R(i)}$ par le dispositif d'application correspondant ; et
p2) contrôle de la fréquence $f_{(i)}$ de l'onde électromagnétique produite par le ou chaque générateur, jusqu'à ce que la puissance réfléchie $P_{R(i)}$ mesurée sur le ou chaque dispositif d'application atteigne un minimum, de sorte que la fréquence $f_{(i)}$ varie jusqu'à trouver un minimum de la puissance réfléchie $P_{R(i)}$;
caractérisé en ce que le procédé se passe d'adaptateur
d'impédance pour réaliser ladite adaptation d'impédance.

Les étapes p1) et p2) automatiques sont particulièrement adaptées pour le contrôle de la puissance réfléchie $P_{R(i)}$ permettant l'adaptation d'impédance.

Selon une possibilité de l'invention, l'étape de génération consiste à générer au moins deux ondes électromagnétiques par au moins deux générateurs, l'étape de guidage consiste à guider chaque onde électromagnétique à destination d'au moins un dispositif d'application, et l'étape de réglage consiste à régler la fréquence de chaque onde électromagnétique indépendamment l'une de l'autre.

Selon une autre possibilité de la divulgation ne s'appliquant pas à l'invention, l'étape de génération consiste à générer N ondes électromagnétiques par N générateurs, l'étape de guidage consiste à guider les N ondes électromagnétiques à destination de N dispositifs d'application, où N est un entier supérieur à 2, et l'étape de réglage consiste à régler la fréquence de chaque onde électromagnétique indépendamment l'une de l'autre.

Dans une réalisation particulière, il existe, pour le ou chaque dispositif d'application (i), un minimum de la puissance réfléchie $P_{R(i)}$ mesurée afin de réaliser une adaptation d'impédance sur le ou chaque dispositif d'application (i) ; ce minimum étant éventuellement égal ou proche de zéro et, pour rappel, peut être fixé à une valeur de puissance seuil donnée ou bien à un pourcentage donné du rapport de la puissance réfléchie sur la puissance incidente.

Ainsi, dans cette réalisation, le procédé vise à minimiser la puissance réfléchie $P_{R(i)}$ sur chaque dispositif d'application (i) afin de réaliser l'adaptation d'impédance.

Le document EP-A2-1643641 divulgue un procédé de traitement micro-onde dans une chambre de gravure par production d'un plasma qui utilise un générateur à état solide pour exciter le plasma, avec l'emploi d'un amplificateur sur la ligne de transmission de l'onde. Une unité d'opération met en oeuvre, sur la base d'une mesure, entre autres, de la puissance réfléchie par la chambre, un contrôle de la fréquence d'oscillation du générateur dans le but de changer le niveau d'amplification de l'amplificateur. Ce document décrit la possibilité de réaliser automatiquement une adaptation d'impédance via un adaptateur «matching unit» classique. Le document JP2011023356 divulgue un procédé de traitement RF dans une chambre de traitement par production d'un plasma qui utilise un générateur radio-fréquence pour exciter le plasma. Un contrôle de la fréquence d'oscillation du générateur est mis en oeuvre sur la base d'une mesure de la puissance réfléchie par la chambre. Ce contrôle fréquentiel permet de réaliser une adaptation d'impédance en se passant d'adaptateur d'impédance.

D'autres caractéristiques et avantages, ne s'appliquant parfois pas à la présente invention, apparaîtront à la lecture de la description détaillée ci-après, de plusieurs exemples de mise en oeuvre non limitatifs, faite en référence aux figures annexées dans lesquelles :

- la figure 1, déjà commentée, est une vue schématique en perspective et coupe partielle d'un réacteur pour une installation de traitement micro-ondes par production de plasma connue ;
- la figure 2, déjà commentée, est une vue schématique partielle d'une installation de traitement micro-ondes par production de plasma connue ;
- la figure 3, déjà commentée, est une vue schématique partielle d'une autre installation de traitement micro-ondes par production de plasma connue ;
- la figure 4, déjà commentée, est une vue schématique partielle d'une autre installation de traitement micro-ondes par production de plasma connue ;
- la figure 5 est une vue schématique d'une première installation de traitement micro-ondes ;
- la figure 6 est une vue schématique d'une deuxième installation de traitement micro-ondes ;
- la figure 7 est une vue schématique d'une troisième installation de traitement micro-ondes ;
- la figure 8 est une vue schématique d'une quatrième installation de traitement micro-ondes ;
- la figure 9 est une vue schématique d'une cinquième installation de traitement micro-ondes ;
- la figure 10 est une vue schématique d'une sixième installation de traitement micro-ondes ;
- la figure 11 est une vue schématique d'une septième installation de traitement micro-ondes ; et
- la figure 12 est une vue schématique d'une huitième installation de traitement micro-ondes.

La description qui suit porte sur une installation 1 de traitement micro-onde sur une charge du type plasma, autrement dit une installation de production d'un plasma dans une chambre de traitement. Il est bien entendu envisageable de mettre en oeuvre l'installation 1 pour d'autres applications, par exemple avec une chambre de traitement du type réacteur chimique contenant un produit solide, liquide et/ou gazeux à traiter par micro-ondes, ou bien dans le cadre d'un traitement médical par application d'un rayonnement micro-onde sur une partie du corps à traiter.

Dans un premier mode de réalisation illustré sur la figure 5, l'installation 1 de production de plasma comporte :

- un réacteur 2 présentant une chambre de traitement 20 dans le volume de laquelle le plasma est produit ;
- une source élémentaire 3 de plasma comprenant un dispositif d'application 30 à l'intérieur de la chambre de traitement 20 d'une onde électromagnétique dans le domaine des micro-ondes, ainsi qu'un système de mesure 31 de la puissance réfléchie par le dispositif d'application 30 ;
- un générateur 4 d'onde électromagnétique dans le domaine des micro-ondes, du type à état solide, raccordé au dispositif d'application 30 par des moyens de guidage 5 de l'énergie électromagnétique, le générateur 4 comprenant un système de réglage fréquentiel 40 conçu pour régler la fréquence de l'onde entre environ 2400 et 2500 MHz, voire dans une autre gamme de fréquence prédéterminée ; et

- un contrôleur 6 relié en entrée au système de mesure 31 et en sortie au système de réglage fréquentiel 40.

Pour la suite de la description et des autres modes de réalisation :

- le ou chaque dispositif d'application 30 est du type applicateur coaxial, mais la divulgation n'est pas limitée à un tel applicateur coaxial et d'autres types de dispositif d'application d'une puissance micro-onde sont envisageables, comme par exemple un tube de décharge (surfatron, cavité Evenson, source downstream, torche plasma semi-métallique, tube diélectrique, etc.), une antenne, une guide d'onde avec une fenêtre diélectrique, etc.
- le ou chaque générateur 4 est du type générateur d'onde électromagnétique à état solide, autrement appelé générateur à transistor, qui présente l'avantage de permettre un contrôle de la fréquence de l'onde électromagnétique, de manière manuelle ou automatique, dans sa gamme de fréquence de fonctionnement (contrairement à un magnétron) ;
- le ou chaque moyen de guidage 5 est réalisé sous la forme d'un câble coaxial particulièrement bien adapté pour un branchement direct sur un générateur 4 à état solide, bien que d'autres formes de moyen de guidage soient envisageables, comme par exemple des guides d'ondes.

Le système de mesure 31 peut être constitué d'un isolateur combinant un circulateur et une charge. Lorsque la source élémentaire émet de la puissance réfléchie, le circulateur dévie cette puissance sur la charge. Par couplage, une fraction de cette puissance est prélevée et mesurée. Connaissant la fraction prélevée (ou coefficient d'atténuation), on en déduit la puissance réfléchie. Le système de mesure peut également être un système de mesure des paramètres S et en particulier le S1,1.

Le contrôleur 6 est conçu pour les six modes de fonctionnement.

Dans un premier mode de fonctionnement, le contrôleur 6 :

- reçoit en entrée la mesure de puissance réfléchie $P_{RM}$ issue du système de mesure 31 ;
- contrôle (ou fait varier) la fréquence f de l'onde électromagnétique produite par le générateur 4 jusqu'à ce que la puissance réfléchie $P_R$ mesurée par le dispositif d'application atteigne sensiblement une première valeur de référence $V_R$.

Autrement dit, le contrôleur 6 trouve la fréquence f pour laquelle la puissance réfléchie $P_R$ est équivalente à la première valeur de référence $V_R$; cette première valeur de référence $V_R$ pouvant être fixée sensiblement à une valeur nulle, ou du moins à la valeur minimale accessible, afin de réaliser une adaptation d'impédance entre le plasma et la source élémentaire 3.

Dans un deuxième mode de fonctionnement, le contrôleur 6 :

- reçoit en entrée la mesure de puissance réfléchie $P_R$ issue du système de mesure 31 ;
- reçoit en entrée la valeur de la puissance incidente $P_{IN}$ sur la source, cette valeur étant issue du générateur 4 auquel est relié le contrôleur 6 ;
- calcule une valeur de consigne $VC_R$ de la puissance réfléchie $P_R$ correspondant à une puissance transmise $P_T$ égale à une seconde valeur de référence $V_T$, soit $VC_R = P_{IN} - V_T$ ;
- contrôle (ou fait varier) la fréquence f de l'onde électromagnétique produite par le générateur 4 jusqu'à ce que la puissance réfléchie $P_R$ mesurée par le dispositif d'application atteigne sensiblement la valeur de consigne $VC_R$.

Ainsi, on effectue un asservissement de la puissance réfléchie $P_R$ à la valeur de consigne $VC_R$ pour réguler la puissance transmise $P_T$ à la seconde valeur de référence $V_T$. Autrement dit, le contrôleur 6 trouve la fréquence f pour laquelle $P_T = V_T$.

Dans un troisième mode de fonctionnement, le contrôleur 6 :

- reçoit en entrée la mesure de puissance réfléchie $P_R$ issue du système de mesure 31 ;
- reçoit en entrée la valeur de la puissance incidente $P_{IN}$ sur la source, cette valeur étant issue du générateur 4 auquel est relié le contrôleur 6 ;
- contrôle (ou fait varier) à la fois la fréquence f et la puissance incidente $P_{IN}$ jusqu'à ce que la puissance réfléchie $P_R$ mesurée par le dispositif d'application atteigne sensiblement une première valeur de référence $V_R$.

Autrement dit, le contrôleur 6 trouve un couple (fréquence f, puissance incidente $P_{IN}$) pour lequel la puissance réfléchie $P_R$ est équivalente à la première valeur de référence $V_R$.

Par exemple, pour que la puissance réfléchie $P_R$ atteigne une première valeur de référence $V_R$ sensiblement nulle, il est envisageable que, dans un premier temps, le contrôleur 6 cherche une fréquence pour laquelle la puissance réfléchie $P_R$ est minimale mais toujours supérieure à zéro et, dans un deuxième temps, le contrôleur 6 cherche la puissance incidente $P_{IN}$ pour laquelle la puissance réfléchie $P_R$ est sensiblement égale à zéro ; le réglage de la puissance incidente $P_{IN}$ n'étant mis en oeuvre que si l'on n'arrive pas à atteindre la première valeur de référence $V_R$ en jouant uniquement sur la fréquence.

Dans un quatrième mode de fonctionnement, le contrôleur 6 :

- reçoit en entrée la mesure de puissance réfléchie $P_R$ issue du système de mesure 31 ;
- reçoit en entrée la valeur de la puissance incidente $P_{IN}$ sur la source, cette valeur étant issue du générateur 4 auquel est relié le contrôleur 6 ;
- contrôle (ou fait varier) à la fois la fréquence f et la puissance incidente $P_{IN}$ jusqu'à ce que la puissance transmise $P_T = P_{IN} - P_R$ soit sensiblement égale à une seconde valeur de référence $V_T$.

Autrement dit, le contrôleur 6 trouve un couple (fréquence f, puissance incidente $P_{IN}$) pour lequel $P_T = V_T$. Par exemple, pour que la puissance transmise $P_T$ atteigne la seconde valeur de référence $V_T$, il est envisageable que, dans un premier temps, le contrôleur 6 cherche une fréquence pour laquelle la puissance transmise $P_T$ se rapproche au maximum de la seconde valeur de référence $V_T$ (sans chercher à minimiser la puissance réfléchie $P_R$) et, dans un deuxième temps, le contrôleur 6 cherche la puissance incidente $P_{IN}$ pour laquelle la puissance transmise $P_T$ est égale à la seconde valeur de référence $V_T$ ; le réglage de la puissance incidente $P_{IN}$ n'étant mis en oeuvre que si l'on n'arrive pas à atteindre la seconde valeur de référence $V_T$ en jouant uniquement sur la fréquence.

Dans un cinquième mode de fonctionnement, le contrôleur 6 :

- reçoit en entrée la mesure de puissance réfléchie $P_{RM}$ issue du système de mesure 31 ;
- reçoit en entrée la valeur de la puissance incidente $P_{IN}$ sur la source, cette valeur étant issue du générateur 4 auquel est relié le contrôleur 6 ;
- contrôle (ou fait varier) la fréquence f jusqu'à ce que la puissance réfléchie $P_R$ atteigne sensiblement une première valeur de référence $V_R$, de préférence jusqu'à ce que la puissance réfléchie $P_R$ atteigne un minimum ;
- contrôle (ou fait varier) la puissance incidente $P_{IN}$ jusqu'à ce que la puissance transmise $P_T = P_{IN} - P_R$ soit sensiblement égale à une seconde valeur de référence $V_T$.

Autrement dit, le contrôleur 6 trouve un couple (fréquence f, puissance incidente $P_{IN}$) pour lequel $P_R = V_R$ ($P_R$ = minimum accessible) et $P_T = V_T$. Pour l'étape de contrôle de la fréquence, il est envisageable que le contrôleur 6 parte de la fréquence initiale, puis fasse varier la fréquence f du coté ou la puissance réfléchie $P_R$ diminue jusqu'à ce qu'il trouve un minimum.

Dans un sixième mode de fonctionnement, l'installation est à production de plasma à la Résonance Cyclotronique Electronique (RCE). Dans ce cas, la source élémentaire 3 comprend en outre une structure magnétique (non illustrée) conçue pour engendrer un champ magnétique de résonance qui, combiné à l'onde électromagnétique, permet de produire un plasma à la Résonance Cyclotronique Electronique (RCE).

Dans ce sixième mode de fonctionnement, le contrôleur 6 :

- calcule une consigne de fréquence $Cf_{(i)}$, pour le ou chaque système de réglage fréquentiel 40, correspondant à une valeur prédéterminée de la surface de résonance de la ou chaque source élémentaire 3 de plasma ; et
- contrôle, pour chaque source élémentaire 3, le système de réglage fréquentiel 40 concerné pour asservir la fréquence $f_{(i)}$ de l'onde électromagnétique produite par le ou chaque générateur 4 à la valeur de consigne $Cf_{(i)}$ correspondante afin que la surface de résonance de la ou chaque source élémentaire 3 de plasma atteigne la valeur prédéterminée correspondante.

Dans un deuxième mode de réalisation illustré sur la figure 6, l'installation 1 de production de plasma est identique à celle du premier mode de réalisation de la figure 5, à la différence qu'elle comprend en outre un adaptateur d'impédance 7 disposé en amont de l'applicateur 30.

Cet adaptateur d'impédance 7 permet ainsi de réaliser une première adaptation d'impédance, éventuellement moyenne, avec un réglage en préalable aux opérations, avant que le contrôleur 6 puisse effectuer une seconde adaptation d'impédance fine et/ou une régulation de la puissance transmise, automatique et en temps réel durant les opérations, notamment en mettant en oeuvre les modes de fonctionnement décrit ci-dessus.

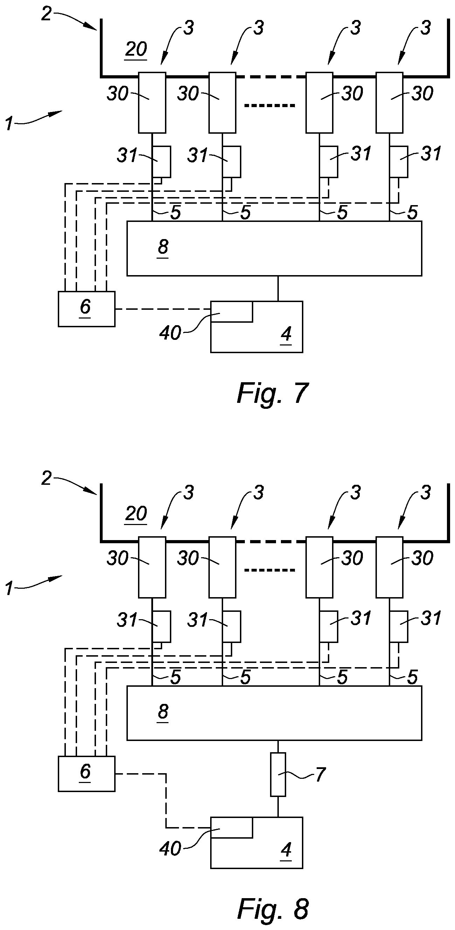

Dans un troisième mode de réalisation illustré sur la figure 7, l'installation 1 de production de plasma comporte :

- un réacteur 2 présentant une chambre de traitement 20 dans le volume de laquelle le plasma est produit ;
- plusieurs sources élémentaires 3 de plasma comprenant chacune un applicateur 30 à l'intérieur de la chambre de traitement 20 d'une onde électromagnétique dans le domaine des micro-ondes, ainsi qu'un système de mesure 31 de la puissance réfléchie par le dispositif d'application 30 correspondant ;
- un générateur 4 d'onde électromagnétique dans le domaine des micro-ondes, du type à état solide, raccordé aux applicateurs 30 par des câbles coaxiaux 5, le générateur 4 comprenant un système de réglage fréquentiel 40 conçu pour régler la fréquence de l'onde entre environ 2400 et 2500 MHz, voire dans une autre gamme de fréquence prédéterminée ; et
- un contrôleur 6 relié en entrée au système de mesure 31 et en sortie au système de réglage fréquentiel 40 ; et
- un diviseur de puissance 8 placé en sortie du générateur 4 et conçu pour diviser la puissance micro-onde générée par le générateur 4 par le nombre k de sources élémentaires 3, le diviseur de puissance 8 présentant k sorties reliées chacune à un applicateur 30 par un câble coaxial 5, chaque sortie du diviseur de puissance 8 prélevant ainsi 1/k de la puissance totale délivrée par le générateur 4 à destination d'un applicateur 30.

Le contrôleur 6 est conçu pour mettre en oeuvre les six modes de fonctionnement décrits ci-dessus, à la différence qu'un seul générateur 4 est associé à plusieurs sources élémentaires 3. Ainsi, le contrôleur 6 peut :

-    dans le premier mode de fonctionnement : effectuer une régulation de la puissance réfléchie $P_{R(i)}$ sur chaque source élémentaire (i) en jouant sur la fréquence f de l'onde générée par le générateur 4 commun, de préférence pour une adaptation d'impédance ;
-    dans le deuxième mode de fonctionnement : effectuer une régulation de la puissance transmise $P_{T(i)}$ sur chaque source élémentaire (i) en jouant sur la fréquence f de l'onde générée par le générateur 4 commun ;
-    dans le troisième mode de fonctionnement : effectuer une régulation de la puissance réfléchie $P_{R(i)}$ sur chaque source élémentaire (i) en jouant sur la fréquence f de l'onde générée par le générateur 4 commun et sur la puissance incidente $P_{IN(i)}$ sur la source (i), sachant que la puissance incidente $P_{IN(i)}$ pour la source (i) correspond à une fraction de la puissance $P_{GEN}$ du générateur 4 après la division de puissance réalisée par le diviseur 8 ;
-    dans le quatrième mode de fonctionnement : effectuer une régulation de la puissance transmise $P_{T(i)}$ sur chaque source élémentaire (i) en jouant sur la fréquence f de l'onde générée par le générateur 4 commun et sur la puissance incidente $P_{IN(i)}$ sur la source (i) (fraction de la puissance $P_{GEN}$ du générateur 4) ;
-    dans le cinquième mode fonctionnement : effectuer, pour chaque source (i), une régulation de la puissance réfléchie $P_{R(i)}$ et une régulation de la puissance transmise $P_{T(i)}$ en jouant sur la fréquence f de l'onde générée par le générateur 4 commun et sur la puissance incidente $P_{IN(i)}$ sur la source (i) (fraction de la puissance $P_{GEN}$ du générateur 4) ; et
-    dans le sixième mode de fonctionnement : effectuer un contrôle de la surface de résonnance, dans les zones de création associées aux sources élémentaires (i), en jouant sur la fréquence f de l'onde générée par le générateur 4 commun.

Bien entendu, cette installation présente une limitation due au fait que le générateur 4 alimente plusieurs sources élémentaires 3, de sorte que les puissances réfléchies $P_{R(i)}$ mesurées sur les différents applicateurs 30 n'atteindront pas toutes exactement une même première valeur de référence $V_{R(i)}$, car il peut exister une dispersion entre les applicateurs 30 et, en outre, les sources élémentaires 3 peuvent interagir entre elles. Il n'en demeure pas moins que le contrôleur 6 permet de réguler globalement et moyennement la puissance réfléchie et/ou la puissance transmise, ainsi que la surface de résonance, sur toutes les sources élémentaires 3, en jouant sur la fréquence f, et éventuellement la puissance $P_{GEN}$, de l'onde générée par l'unique générateur 4.

Mais, en théorie, si les applicateurs 30 sont identiques, ou plus exactement si les lignes micro-ondes entre le générateur 4 et chaque source 3 sont identiques, et si la division de la puissance réalisée par le diviseur 8 est équitable quelque soit la fréquence f, et si les conditions opératoires sont identiques en bout de chaque applicateur 30 (autrement dit si le plasma est uniforme dans le voisinage des applicateurs 30) alors la fréquence f peut être identique chacune des sources 3 afin de réaliser l'adaptation d'impédance et/ou la régulation de puissance transmise et/ou le contrôle des surfaces de résonance.

Dans un quatrième mode de réalisation illustré sur la figure 8, l'installation 1 de production de plasma est identique à celle du troisième mode de réalisation de la figure 7, à la différence qu'elle comprend en outre un adaptateur d'impédance 7 disposé entre le générateur 4 et le diviseur de puissance 8.

Cet adaptateur d'impédance 7 permet ainsi de réaliser une première adaptation d'impédance, éventuellement moyenne, avec un réglage en préalable aux opérations, avant que le contrôleur 6 puisse effectuer une seconde adaptation d'impédance pour l'ensemble des sources élémentaires 3, de manière automatique et en temps réel durant les opérations. De manière générale, le contrôleur 6 est conçu pour mettre en oeuvre les six modes de fonctionnement décrits ci-dessus, à la différence qu'une adaptation d'impédance commune à l'ensemble des sources 3 est réalisée avec l'adaptateur d'impédance 7 commun.

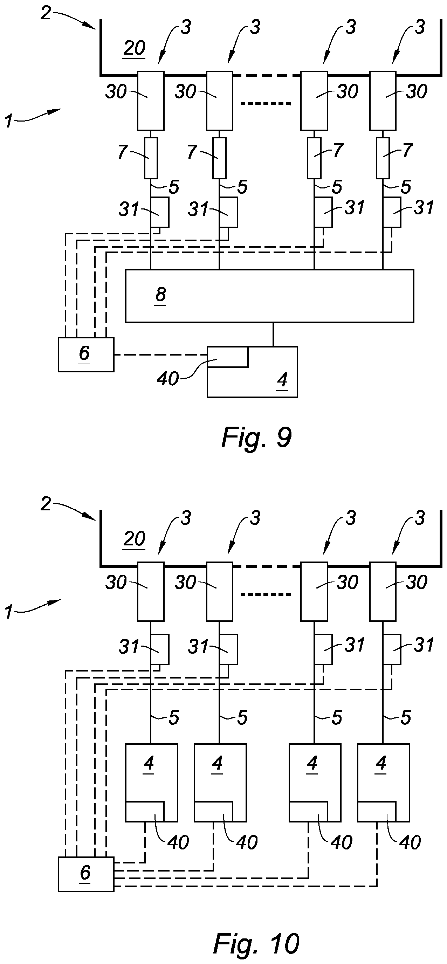

Dans un cinquième mode de réalisation illustré sur la figure 9, l'installation 1 de production de plasma est identique à celle du troisième mode de réalisation de la figure 7, à la différence qu'elle comprend en outre plusieurs adaptateurs d'impédance 7 disposé entre le diviseur de puissance 8 et les applicateurs 30, avec un adaptateur d'impédance 7 par applicateur 30.

Ces adaptateurs d'impédance 7 permettent ainsi de réaliser une première adaptation d'impédance, éventuellement moyenne, pour chaque source élémentaire 3, avec un réglage en préalable aux opérations. Ensuite, le contrôleur 6 permet d'effectuer une seconde adaptation d'impédance pour l'ensemble des sources élémentaires 3, de manière automatique et en temps réel durant les opérations. De manière générale, le contrôleur 6 est conçu pour mettre en oeuvre les six modes de fonctionnement décrits ci-dessus, à la différence qu'une adaptation d'impédance individuelle pour chaque source 3 peut être réalisée avec chaque adaptateur d'impédance 7, et ce indépendamment d'une source 3 à l'autre. De cette manière, il est possible de compenser des différences entre les applicateurs 30 (ou plus exactement entre les lignes micro-ondes entre le générateur 4 et chaque source 3), des disparités dans la division de puissance réalisée par le diviseur 8, et des inhomogénéités de plasma en bout des applicateurs 30.

Dans un sixième mode de réalisation illustré sur la figure 10, l'installation 1 de production de plasma comporte :

- un réacteur 2 présentant une chambre de traitement 20 dans le volume de laquelle le plasma est produit ;
- plusieurs sources élémentaires 3 de plasma comprenant chacune un applicateur 30 à l'intérieur de la chambre de traitement 20 d'une onde électromagnétique dans le domaine des micro-ondes, ainsi qu'un système de mesure 31 de la puissance réfléchie par le dispositif d'application 30 correspondant ; et
- plusieurs générateurs 4 d'onde électromagnétique dans le domaine des micro-ondes, du type à état solide, raccordé chacun à un applicateur 30 par un câble coaxial 5, avec un générateur 4 par source élémentaire 3, chaque générateur 4 comprenant un système de réglage fréquentiel 40 conçu pour régler la fréquence de l'onde entre environ 2400 et 2500 MHz, voire dans une autre gamme de fréquence prédéterminée ; et
- un contrôleur 6 relié en entrée aux systèmes de mesure 31 des différentes sources élémentaires 3 et en sortie aux systèmes de réglage fréquentiel 40 des différents générateurs 4.

Le contrôleur 6 est conçu pour mettre en oeuvre les six modes de fonctionnement décrits ci-dessus, à la différence qu'à chaque générateur 4 est associé une unique source élémentaire 3. Ainsi, le contrôleur 6 peut :

- dans le premier mode de fonctionnement : effectuer une régulation de la puissance réfléchie $P_{R(i)}$ sur chaque source élémentaire (i) (de manière indépendante d'une source à l'autre) en jouant sur la fréquence $f_{(i)}$ de l'onde générée par le générateur 4 associé, de préférence pour une adaptation d'impédance ;
- dans le deuxième mode de fonctionnement : effectuer une régulation de la puissance transmise $P_{T(i)}$ sur chaque source élémentaire (i) (de manière indépendante d'une source à l'autre) en jouant sur la fréquence $f_{(i)}$ de l'onde générée par le générateur 4 associé ;
- dans le troisième mode de fonctionnement : effectuer une régulation de la puissance réfléchie $P_{R(i)}$ sur chaque source élémentaire (i) en jouant sur la fréquence $f_{(i)}$ de l'onde générée par le générateur 4 associé et sur la puissance incidente $P_{IN(i)}$ sur la source (i) (de manière indépendante d'une source à l'autre), sachant que la puissance incidente $P_{IN(i)}$

pour la source (i) correspond sensiblement à la puissance $P_{GEN(i)}$ du générateur 4 associé, aux pertes de lignes près (de sorte que jouer sur la puissance incidente $P_{IN(i)}$ sur la source (i) revient à jouer sur la puissance $P_{GEN(i)}$ du générateur 4 associé) ;

- dans le quatrième mode de fonctionnement : effectuer une régulation de la puissance transmise $P_{T(i)}$ sur chaque source élémentaire (i) (de manière indépendante d'une source à l'autre) en jouant sur la fréquence $f_{(i)}$ de l'onde générée par le générateur 4 associé et sur la puissance incidente $P_{IN(i)}$ sur la source (i) (et donc sur la puissance $P_{GEN(i)}$ du générateur 4 associé) ;
- dans le cinquième mode fonctionnement : effectuer, pour chaque source (i), une régulation de la puissance réfléchie $P_{R(i)}$ et une régulation de la puissance transmise $P_{T(i)}$ en jouant sur la fréquence $f_{(i)}$ de l'onde générée par le générateur 4 associé et sur la puissance incidente $P_{IN(i)}$ sur la source (i) (et donc sur la puissance $P_{GEN(i)}$ du générateur 4 associé) ; et
- dans le sixième mode de fonctionnement : effectuer un contrôle de la surface de résonnance, et donc des zones de création associées à chaque source élémentaire (i) (de manière indépendante d'une source à l'autre), en jouant sur la fréquence $f_{(i)}$ de l'onde générée par le générateur 4 associé.

Ainsi, le contrôleur 6 contrôle les systèmes de réglage fréquentiel 31 (contrôle de la fréquence) et les générateurs 4 (contrôle de la puissance incidente) indépendamment les uns des autres.

Par exemple, dans le premier mode de fonctionnement (régulation de la puissance réfléchie), pour la première source élémentaire 3 on mesure une première puissance réfléchie $P_{R(1)}$, et le contrôleur 6 trouve une première fréquence $f_{(1)}$ pour le premier générateur 4 permettant à cette puissance réfléchie $P_{R(1)}$ d'atteindre une première valeur de référence $V_{R(1)}$, par exemple nulle ou du moins minimale. La régulation de la puissance réfléchie $P_{R(1)}$ par variation de la fréquence du premier générateur 4 s'effectue selon une première boucle d'asservissement qui concerne uniquement la première source élémentaire 3 et le premier générateur 4.

De même, pour la seconde source élémentaire 3 on mesure une seconde puissance réfléchie $P_{R(2)}$, et le contrôleur 6 trouve une seconde fréquence $f_{(2)}$ pour le second générateur 4 permettant à cette puissance réfléchie $P_{R(2)}$ d'atteindre une seconde valeur de référence $V_{R(2)}$, par exemple nulle ou du moins minimale. La régulation de la puissance réfléchie $P_{R(2)}$ par variation de la fréquence du second générateur 4 s'effectue selon une seconde boucle d'asservissement qui concerne uniquement la seconde source élémentaire 3 et le second générateur 4.

Cette installation présente l'avantage, par rapport aux troisième, quatrième et cinquième modes de réalisation, d'effectuer la régulation de la puissance (adaptation d'impédance) et/ou la régulation de puissance transmise et/ou le contrôle des surfaces de résonance pour chaque source élémentaire 3, indépendamment l'une de l'autre. Cette installation permet ainsi de contrôler la puissance transmise sur chaque source élémentaire 3, toujours indépendamment l'une de l'autre, par exemple dans un souci d'homogénéisation du plasma, en jouant sur les fréquences de chaque générateur 4, indépendamment l'un de l'autre.

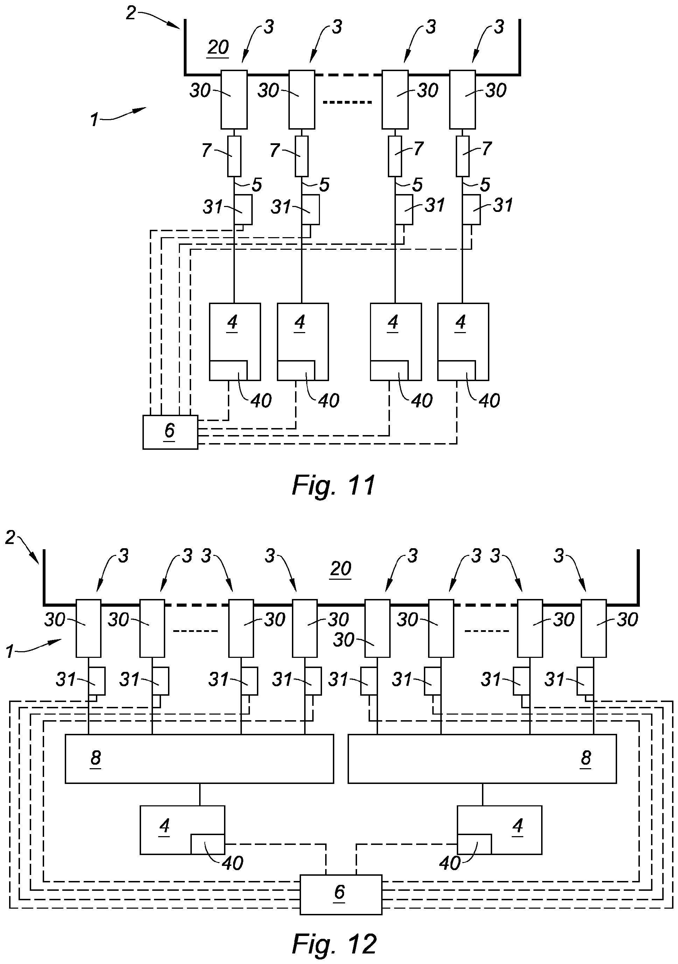

Dans un septième mode de réalisation illustré sur la figure 11, l'installation 1 de production de plasma est identique à celle du sixième mode de réalisation de la figure 10, à la différence qu'elle comprend en outre plusieurs adaptateurs d'impédance 7 disposé entre les générateurs 4 et les applicateurs 30, avec un adaptateur d'impédance 7 par applicateur 30.

Ces adaptateurs d'impédance 7 permettent ainsi de réaliser une première adaptation d'impédance, éventuellement moyenne, pour chaque source élémentaire 3, avec un réglage en préalable aux opérations. Ensuite, le contrôleur 6 permet de mettre en oeuvre les six modes de fonctionnement décrits ci-dessus, comme par exemple d'effectuer une seconde adaptation d'impédance fine pour chaque source élémentaire 3 (premier, troisième et cinquième modes de fonctionnement), de manière indépendante, automatique et en temps réel durant les opérations pour chaque source élémentaire 3.

Dans un huitième mode de réalisation illustré sur la figure 12, l'installation 1 de production de plasma comprend une première sous-installation conforme au troisième mode de réalisation de la figure 7, et une seconde sous-installation également conforme au troisième mode de réalisation de la figure 7, où les applicateurs 30 des deux sous-installations sont disposés à l'intérieur d'une même chambre de traitement 20 d'un même réacteur 2.

Ainsi, la première sous-installation comprend :

- plusieurs sources élémentaires 3 de plasma comprenant chacune un applicateur 30 à l'intérieur de la chambre de traitement 20 et un système de mesure 31 de la puissance réfléchie par le dispositif d'application 30 correspondant ;
- un générateur 4 d'onde électromagnétique dans le domaine des micro-ondes, raccordé aux applicateurs 30 par des câbles coaxiaux 5, le générateur 4 comprenant un système de réglage fréquentiel 40 conçu pour régler la fréquence de l'onde entre environ 2400 et 2500 MHz, voire dans une autre gamme de fréquence prédéterminée ; et
- un diviseur de puissance 8 placé en sortie du générateur 4 et présentant k sorties reliées chacune à un applicateur 30 par un câble coaxial 5, chaque sortie du diviseur de puissance 8 prélevant ainsi 1/k de la puissance totale délivrée par le générateur 4 à destination d'un applicateur 30.

Ainsi, la seconde sous-installation comprend :

- plusieurs sources élémentaires 3 de plasma comprenant chacune un applicateur 30 à l'intérieur de la même chambre de traitement 20 et un système de mesure 31 de la puissance réfléchie par le dispositif d'application 30 correspondant ;
- un générateur 4 d'onde électromagnétique dans le domaine des micro-ondes, du type à état solide, raccordé aux applicateurs 30 par des câbles coaxiaux 5, le générateur 4 comprenant un système de réglage fréquentiel 40 conçu pour régler la fréquence de l'onde entre environ 2400 et 2500 MHz, voire dans une autre gamme de fréquence prédéterminée ; et
- un diviseur de puissance 8 placé en sortie du générateur 4 et présentant m sorties (où m n'est pas nécessairement égal à k) reliées chacune à un applicateur 30 par un câble coaxial 5, chaque sortie du diviseur de puissance 8 prélevant ainsi 1/m de la puissance totale délivrée par le générateur 4 à destination d'un applicateur 30.

En outre, l'installation 1 comprend un contrôleur 6 relié en entrée aux systèmes de mesure 31 de toutes les sources élémentaires 3, et en sortie aux systèmes de réglage fréquentiel 40 des deux générateurs 4.

Bien entendu, il est envisageable dans l'une et/ou l'autre des deux sous-installations de prévoir un adaptateur d'impédance par générateur (comme dans le cas du quatrième mode de réalisation de la figure 8) ou un adaptateur d'impédance par applicateur (comme dans le cas du cinquième mode de réalisation de la figure 8).

Il est également envisageable de rajouter une nouvelle sous-installation, ou de remplacer l'une des deux sous-installations par une nouvelle sous-installation, cette nouvelle sous-installation pouvant être du type du premier, deuxième, sixième ou septième modes de réalisation, avec un générateur par applicateur. Dans ce cas, l'installation comprend toujours un seul contrôleur relié aux différents systèmes de mesure 31 et aux différents systèmes de réglage fréquentiel 40.

Bien entendu l'exemple de mise en oeuvre évoqué ci-dessus ne présente aucun caractère limitatif et d'autres améliorations et détails peuvent être apportés à l'installation selon l'invention, sans pour autant sortir du cadre de l'invention où d'autres formes de dispositif d'application et/ou de moyen de guidage de l'onde électromagnétique peuvent par exemple être réalisées.

L'invention est définie par les revendications. 30

## Revendications

1. Procédé de traitement micro-onde d'une charge, comprenant les étapes suivantes :

- génération d'au moins une onde électromagnétique dans le domaine des micro-ondes par au moins un générateur (4) du type à état solide ;
- guidage de la ou chaque onde électromagnétique à destination d'au moins un dispositif d'application (30) de l'onde électromagnétique ;
- application par le ou chaque dispositif d'application (30) de la ou chaque onde électromagnétique sur la charge ;

une étape de réglage automatisé de la fréquence de la ou chaque onde électromagnétique afin de minimiser la puissance réfléchie $P_{R(i)}$ sur le ou chaque dispositif d'application (30) pour assurer une adaptation d'impédance permettant d'optimiser le transfert de la ou chaque onde électromagnétique à destination de la charge, de manière automatique et en temps réel, avec les étapes suivantes :

p1) mesure, pour le ou chaque dispositif d'application (30), de la puissance réfléchie $P_{R(i)}$ par le dispositif d'application (30) correspondant ; et
p2) contrôle de la fréquence $f_{(i)}$ de l'onde électromagnétique produite par le ou chaque générateur (4), jusqu'à ce que la puissance réfléchie $P_{R(i)}$ mesurée sur le ou chaque dispositif d'application (30) atteigne un minimum, de sorte que la fréquence $f_{(i)}$ varie jusqu'à trouver un minimum de la puissance réfléchie $P_{R(i)}$;

**caractérisé**
**en ce que** le procédé se passe d'adaptateur d'impédance pour réaliser ladite adaptation d'impédance.

2. Procédé selon la revendication 1, dans lequel l'étape de génération consiste à générer au moins deux ondes électromagnétiques par au moins deux générateurs (4), l'étape de guidage consiste à guider chaque onde électromagnétique à destination d'au moins un dispositif d'application (30), et l'étape de réglage consiste à régler la fréquence de chaque onde électromagnétique indépendamment l'une de l'autre.

3. Procédé selon les revendications 1 ou 2, dans lequel le minimum de la puissance réfléchie $P_{R(i)}$ mesurée, pour le ou chaque dispositif d'application (30), est égal ou proche de zéro.

4. Procédé selon l'une quelconque des revendications 1 à 3, dans lequel la fréquence $f_{(i)}$ de l'onde électromagnétique produite par le ou chaque générateur (4) est réglée dans une plage de fréquence choisie du domaine des micro-ondes, comme par exemple dans une plage de fréquence comprise entre environ 2400 et 2500 MHz, ou par exemple entre environ 5725 et 5875 MHz, voire dans une autre plage de fréquence prédéterminée appartenant au domaine des micro-ondes.

**Patentansprüche**

1. Verfahren zur Mikrowellenbehandlung einer Last, umfassend die folgenden Schritte:

- Erzeugen von mindestens einer elektromagnetischen Welle im Bereich der Mikrowellen durch mindestens einen Generator (4) vom Typ im festen Zustand;
- Führen der oder jeder elektromagnetischen Welle an das Ziel von mindestens einer Anwendungsvorrichtung (30) der elektromagnetischen Welle;
- Anwenden durch die oder jede Anwendungsvorrichtung (30) der oder jeder elektromagnetischen Welle auf die Last;
- einen Schritt des automatischen Einstellens der Frequenz der oder jeder elektromagnetischen Welle, um die reflektierte Leistung $P_{R(i)}$ auf der oder jeder Anwendungsvorrichtung (30) zu minimieren, um eine Impedanzanpassung sicherzustellen, die ermöglicht, die Übertragung der oder jeder elektromagnetischen Welle an das Ziel der Last auf automatische Weise und in Echtzeit mit den folgenden Schritten zu optimieren:

p1) Messen, für die oder jede Anwendungsvorrichtung (30), der reflektierten Leistung $P_{R(i)}$ durch die entsprechende Anwendungsvorrichtung (30); und
p2) Steuern der Frequenz $f_{(i)}$ der elektromagnetischen Welle, erzeugt durch den oder jeden Generator (4), bis die reflektierte Leistung $P_{R(i)}$, gemessen auf der oder jeder Anwendungsvorrichtung (30), ein Minimum erreicht, so dass die Frequenz $f_{(i)}$ variiert, bis ein Minimum der reflektierten Leistung $P_{R(i)}$ gefunden wird;

**dadurch gekennzeichnet, dass** das Verfahren als Impedanzadapter dient, um die Impedanzanpassung durchzuführen.

2. Verfahren nach Anspruch 1, wobei der Schritt des Erzeugens darin besteht, mindestens zwei elektromagnetische Wellen durch mindestens zwei Generatoren (4) zu erzeugen, der Schritt des Führens darin besteht, jede elektromagnetische Welle an das Ziel von mindestens einer Anwendungsvorrichtung (30) zu führen, und der Schritt des Einstellens darin besteht, die Frequenz jeder elektromagnetischen Welle unabhängig voneinander einzustellen.

3. Verfahren nach Anspruch 1 oder 2, wobei das Minimum der reflektierten Leistung $P_{R(i)}$, gemessen für die oder jede Anwendungsvorrichtung (30), gleich oder nahe null ist.

**4.** Verfahren nach einem der Ansprüche 1 bis 3, wobei die Frequenz $f_{(i)}$ der elektromagnetischen Welle, erzeugt durch den oder jeden Generator (4), in einem Frequenzbereich eingestellt ist, ausgewählt aus dem Bereich der Mikrowellen, wie z. B. in einem Frequenzbereich, enthalten zwischen ungefähr 2400 und 2500 MHz, oder z. B. zwischen ungefähr 5725 und 5875 MHz, oder einem anderen vorbestimmten Frequenzbereich, der Teil des Bereichs der Mikrowellen ist.

**Claims**

**1.** A method for the microwave treatment of a load, comprising the following steps:

- generating at least one electromagnetic wave in the microwave range by at least one solid state generator (4);
- guiding the or each electromagnetic wave to at least one application device (30) of the electromagnetic wave;
- applying by the or each application device (30) the or each electromagnetic wave on the load;
- a step for automated adjustment of the frequency of the or each electromagnetic wave in order to minimize the reflected power $P_{R(i)}$ on the or each application device (30) to ensure an impedance matching allowing to optimize the transfer of the or each electromagnetic wave to the load, automatically and in real time, with the following steps:

p1) measuring, for the or each application device (30), the reflected power $P_{R(i)}$ by the corresponding application device (30); and
p2) monitoring the frequency $f_{(i)}$ of the electromagnetic wave produced by the or each generator (4), until the reflected power $P_{R(i)}$ measured at the or each application device (30) reaches a minimum, so that the frequency $f_{(i)}$ varies until a minimum of the reflected power $P_{R(i)}$ is found;

**characterized in that** the method does without matching device to perform said impedance matching.

**2.** The method according to claim 1, wherein the generating step consists in generating at least two electromagnetic waves by at least two generators (4), the guiding step consists in guiding each electromagnetic wave to at least one application device (30), and the adjusting step consists in adjusting the frequency of each electromagnetic wave independently of each other.

**3.** The method according to claim 1 or 2, wherein the minimum of the measured reflected power $P_{R(i)}$, for the or each application device (30), is equal or close to zero.

**4.** The method according to any one of claims 1 to 3, wherein the frequency $f_{(i)}$ of the electromagnetic wave produced by the or each generator (4) is adjusted in a selected frequency range of the microwave range, as for example in a frequency range comprised between approximately 2400 and 2500 MHz, or for example between approximately 5725 and 5875 MHz, or even in another predetermined frequency range belonging to the microwave range.

Fig. 1

Fig. 2

Fig. 3

Fig. 4

Fig. 5

Fig. 6

Fig. 7

Fig. 8

Fig. 9

Fig. 10

Fig. 11

Fig. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0120710 A1
- EP 1643641 A2
- JP 2011023356 B